# EUROPEAN PATENT APPLICATION

(11) **EP 0 907 201 A1**
(43) Date of publication of application: **07.04.1999**
(21) Application number: 97830491.3
(22) Date of filing: 03.10.1997
(51) Int. Cl.: H01L 21/3105

(54) **Planarization method for integrated semiconductor electronic devices**

(71) Applicant: STMicroelectronics S.r.l., 20041 Agrate Brianza (Milano) (IT)
(72) Inventor: DeSanti, Giorgio, 20124 Milano (IT); Zanotti, Luca, 20041 Agrate Brianza (Milano) (IT); Bacchetta, Maurizio Emanuele, 20100 Milano (IT)
(74) Representative: Botti, Mario

(57) **Abstract**

A planarization method for improving the planarity of electronic devices integrated on a semiconductor substrate (1), said devices comprising a plurality of active elements formed with gate regions (2) which stand proud of the substrate (1) surface and define trench regions (3) therebetween. The method provides for the deposition, into said trench regions (3), of a dielectric ply structure comprising a first layer (4) of oxide and a second layer (5) of oxide deposited over said first layer (4). Said first layer (4) is formed by high density plasma chemical vapor deposition (HDP-CVD) and said second layer (5) is a doped silicon oxide. A planarizing step is further applied by chemio-mechanical polishing (CMP) of said second layer (5).

## Description

### Field of the Invention

This invention relates to a planarization method for semiconductor-integrated electronic devices.

Specifically, the invention relates to a planarization method for improving the planarity of electronic devices integrated on a semiconductor substrate, said devices including, for example, a plurality of active elements formed with gate regions standing proud of the substrate surface and defining trench regions therebetween, the method providing for the deposition, into said trench regions, of a dielectric ply structure comprising a first oxide layer, and a second oxide layer deposited on top of said first layer.

### Background Art

As is well known, the number of transistors that the manufacturers of electronic circuits succeed to integrate on a single chip doubles from one year to the next.

This doubled density generally does not reflects in twice the cost, and the cost-to-performance ratio of semiconductor integrated circuits, such as memories or microprocessors, has undergone substantial improvements through the years.

It seems appropriate to wonder, however, to what extent can this process of chip crowding and miniaturizing be carried.

The process of fabricating a semiconductor chip is still based on a number of sequential operations wherein the semiconductor is subjected to photolithographic steps, exposed to light, treated with solvents and etched, and subjected to dopant implantations or the deposition of dielectric or conductive layers; all this to produce on its surface a circuit layout corresponding to a desired circuit architecture.

A typical instance of this is a plurality of active storage elements, formed by MOS technology with respective floating gate regions which rise above the substrate surface distinctly and in parallel, needing reduction to a planar architecture in order to accommodate the deposition of an overlying conductive layer.

To meet this requirement, a first prior proposal has been that of depositing a ply structure comprised of a first undoped oxide layer and a second oxide layer doped with phosphorus and/or boron.

This ply structure is subjected to a reflow thermal treatment.

Reflowing must be carried out at a high temperature, which may pose problems due to the thermal stressing undergone by the semiconductor device.

Furthermore, in the fabrication of ULSI devices, additional silicide, e.g. tungsten or titanium silicide, layers are used increasingly more often to lower contact resistances which may become quite significant in semiconductor devices smaller than 0.35 µm.

In particular, the formation of these titanium silicide layers is incompatible with high-temperature thermal treatments, that is treatments at temperatures above 880°C. Accordingly, planarization techniques which provide for reflowing at high temperatures (≥950°C) cannot be used.

It should be further mentioned that, to meet the requirement for good planarization, the state of the art also proposes a second solution, which consists of using a double layer of undoped dielectric materials having different densities or resistances.

For example, it has been suggested of isolating the plurality of floating gates from one another by depositing a first dielectric layer of TEOS (TetraEthylOrthoSilicate). This first dielectric layer is then overlaid with the deposition a second dielectric layer of SOG (Spin-On Glass).

This SOG depositing step includes a preliminary spinning step, wherein the material is spread while in a highly viscous liquid state, followed by a hardening step using thermal curing techniques at an illustrative temperature of 400°C.

Thereafter, the planarized surface is subjected to selective etching in order to thoroughly remove the SOG dielectric layer and confine the TEOS layer to within the interspaces between the plurality of floating gates.

However, this prior solution has a serious drawback in that it is hardly repeatable, unless applied by means of special equipment, which would raise the cost of the end product significantly. Furthermore, the etching step is difficult to control because of the changing selectivity of the underlying layer uncovered as the etching progresses.

The technical problem which underlies this invention is to provide a novel planarization method with a dielectric ply structure which can overcome the aforementioned limitations and drawbacks of the prior art.

### Summary of the Invention

The solving idea behind this invention is to deposit a ply structure comprising a first oxide layer deposited by HDCVD, and a second doped oxide layer subsequently deposited by a conventional CVD technique.

The first layer has good filling properties, while the second layer with capping function can be planarized uniformly.

The planarizing step is carried out using an etching technique of a chemio-mechanical (CMP) type.

Based on this solving idea, the technical problem is solved by a method as previously indicated and defined in the characterizing part of Claim 1.

The features and advantages of the deposition method according to this invention will be apparent from the following description of an embodiment thereof, given by way of non-limitative example with reference to the accompanying drawings.

### Brief Description of the Drawings

In the drawings:
Figure 1 is a vertical cross-section view, drawn to an enlarged scale, showing schematically a portion of a semiconductor electronic device prior to the planarizing step;
Figure 2 is a vertical cross-section view, drawn to an enlarged scale, showing schematically a portion of the semiconductor electronic device in Figure 1 which has been applied a planarizing step in accordance with this invention.

### Detailed Description

A preferred embodiment of the planarization method according to this invention will be described in detail with reference to the drawing figures.

For the purpose, a semiconductor portion intended for forming storage cells of a memory array will be considered illustratively, without the Applicant being limited thereto.

This portion comprises a semiconductor substrate 1 having a plurality of active elements integrated thereon which are formed, using MOS technology, with floating gate regions 2 which extend in parallel across the substrate 1 at a spacing from one another.

These floating gate regions 2 define a plurality of trenches 3 in the surface of the semiconductor substrate, with each trench being bounded by two adjacent gate regions.

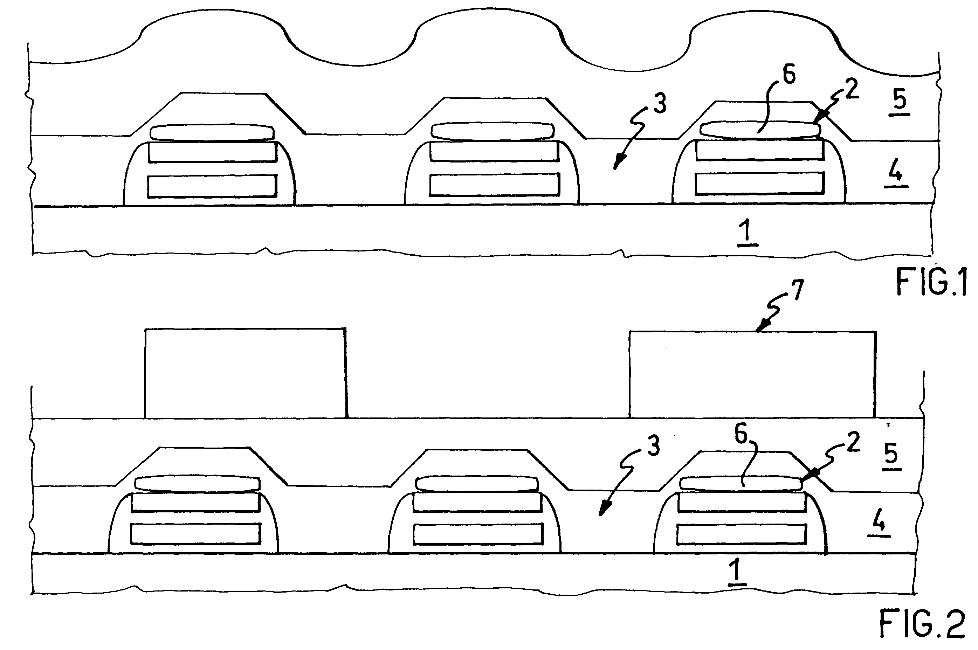

More particularly, it can be seen from Figure 1 that each floating gate region 2 comprises a basically sandwich structure of different materials, wherein conductive layers alternate with isolation layers. This sandwich structure is configured to allow, under given bias conditions, charge to be retained within a conductive layer interposed between two layers of an insulating material.

In detail, each floating gate region or strip 2 comprises: a first thin oxide layer grown over the semiconductor substrate 1; a first conductive layer of polysilicon, or polyl, deposited onto the thin oxide layer; a third isolating oxide layer, e.g. of ONO (Oxide-Nitride-Oxide); and a second conductive layer of polysilicon, or poly cap, deposited onto said third isolating layer.

Advantageously, the floating gate may include a third layer 6 with relatively low resistivity, of titanium or tungsten silicide.

When viewed in cross-section to an enlarged scale, each region 2 appears as an elevation or "stack" protruding from the surface of the substrate 1.

The method of this invention comprises an initial step of depositing a first layer 4 of a dielectric insulating material which acts as a filler and is deposited using an HDPCVD (High Density Plasma Chemical Vapor Deposition) technique, so as to obtain a good filling of the trenches 3.

This first dielectric layer 4 is a silicon oxide, or alternatively, silicon oxynitride or nitride, and may be undoped or doped with either phosphorus or boron/phosphorus.

Thereafter, a second doped dielectric layer 5, particularly a layer 5 of silicon oxide doped with either phosphorus or boron/phosphorus, is deposited.

Preferably, this second layer 5 is deposited using either an APCVD (Atmospheric Pressure Chemical Vapor Deposition) technique, or SACVD (Sub-Atmospheric Chemical Vapor Deposition) technique, or LPCVD (Low Pressure Chemical Vapor Deposition) technique, so as to provide a uniform planarization.

To set the second layer 5 so as to make it more closely similar to thermal oxides, a thermal setting cycle is applied.

The filling of the trench regions 3 is performed so as to also cover the floating gate regions 2.

This is followed by a CMP (Chemical Mechanical Polishing) treatment to provided mechanically a truly planar surface.

A conductive layer 7 is then formed selectively, as shown in Figure 2.

The method of this invention does solve the technical problem, and offers a number of advantages, foremost among which is the fact that the process described hereinabove is compatible with any of the miniaturization techniques to come.

In addition, by using dielectrics which do not require high settting or reflowing temperatures, additional conductive layers can be introduced, in particular layers of titanium silicide which would be incompatible with thermal treatments at more than 880°C.

The method disclosed hereinabove ensures excellent filling of the areas to be planarized, on account of the HDPCVD technique applied and the good degree of planarization attained even in the most critical areas.

The process has good repeatability and can be implemented on a production line without burdening it with extensive checking procedures.

In addition, the deposition of oxides by the HDPCVD or APCVD or SACVD or LPCVD techniques can be carried out using industrially well proven procedures with satisfactory yields.

In conclusion, the method of this invention allows circuit architectures of the type described above to be planarized, while reconciling the need for low-temperature process steps with the provision of reliable planarizing dielectric structures which exhibit good filling properties.

## Claims

1. A planarization method for improving the planarity of electronic devices integrated on a semiconductor substrate (1), said devices comprising, for example, a plurality of active elements formed with gate regions (2) which stand proud of the substrate (1) surface and define trench regions (3) therebetween, the method providing for the deposition, into said trench regions (3), of a dielectric ply structure comprising a first layer (4) of oxide and a second layer (5) of oxide deposited over said first layer (4), characterized in that said first layer (4) is formed by high density plasma chemical vapor deposition (HDP-CVD) and said second layer (5) is a doped silicon oxide, and that a thermal setting treatment is applied at temperatures of 880°C or less, a subsequent planarizing step with chemio-mechanical polishing (CMP) of said second layer (5) being also provided.

2. A method according to Claim 1, characterized in that the gate regions (2) comprise a silicide layer (6).

3. A method according to Claim 1, characterized in that said first layer (4) is either undoped silicon oxide, or silicon oxynitride, or silicon nitride.

4. A method according to Claim 1, characterized in that said first layer (4) is silicon oxide doped with phosphorus.

5. A method according to Claim 1, characterized in that said first layer (4) is silicon oxide doped with boron and phosphorus.

6. A method according to Claim 1, characterized in that said second layer (5) is silicon oxide doped with phosphorus.

7. A method according to Claim 1, characterized in that said second layer (5) is silicon oxide doped with boron and phosphorus.

8. A method according to either Claim 6 or 7, characterized in that said second oxide layer (5) is deposited using an APCVD technique.

9. A method according to either Claim 6 or 7, characterized in that said second oxide layer (5) is deposited using an SACVD technique.

10. A method according to either Claim 6 or 7, characterized in that said second oxide layer (5) is deposited using an LPCVD technique.
